Europäisches Patentamt

European Patent Office

Office européen des brevets

(19)

(11) Publication number: **0 338 737**
**A2**

## (12) EUROPEAN PATENT APPLICATION

(21) Application number: **89303736.6**

(22) Date of filing: **14.04.89**

(51) Int. Cl.⁴: **H03K 3/53 , H03K 3/55**

(30) Priority: **16.04.88 GB 8809030**
**16.05.88 GB 8811586**

(43) Date of publication of application:
**25.10.89 Bulletin 89/43**

(84) Designated Contracting States:
**BE CH DE FR IT LI NL SE**

(71) Applicant: **EEV LIMITED**
**106 Waterhouse Lane**
**Chelmsford Essex CM1 2QU(GB)**

(72) Inventor: **Nicholls, Nigel S.**
**36 Worcester Road**
**Great Malvern Worcestershire(GB)**

(74) Representative: **Cockayne, Gillian et al**
**The General Electric Company plc Patent**
**Department GEC Marconi Research Centre**
**West Hanningfield Road**
**Great Baddow, Chelmsford Essex CM2**
**8HN(GB)**

(54) Circuit arrangements.

(57) A circuit arrangement for applying a current pulse to a load 9, such as a magnetron or klystron, includes a main switch 14 and an auxiliary switch 15. Prior to transmission of the pulse, charging current is applied via an inductor 10 to a pulse forming network 12. Once charging is complete, the main switch 14 is triggered and the pulse is applied to the load 9 via a pulse transformer 13. After transmission of the pulse, energy is transferred from the core of the transformer 13 to the pulse forming network 12. When maximum energy transfer has almost occurred, the auxiliary switch 15 is triggered, causing an inverse voltage to be applied across the main switch 14. This ensures that the main switch 14 can undergo recovery, even under adverse operating conditions.

Fig.2

## CIRCUIT ARRANGEMENTS

This invention relates to circuit arrangements and more particularly, but not exclusively, to modulators employing thyratron-like switches to drive unidirectionally conducting loads via a pulse transformer and pulse forming network.

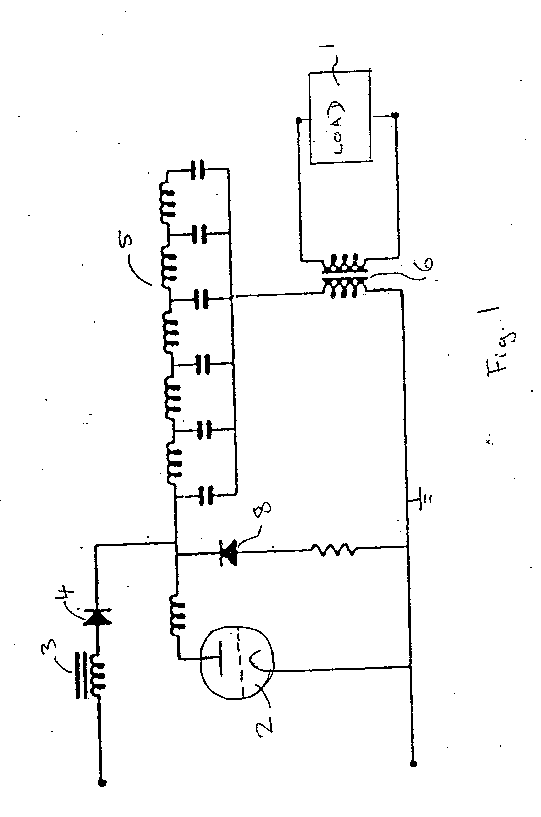

Figure 1 illustrates a known modulator for applying a current pulse through a unidirectionally conducting load 1 and includes a thyratron 2 for switching the pulse. Initially, the thyratron 2 is in a non-conducting state and charging current is applied via an inductor 3 and diode 4 to build up voltage across a pulse forming network (PFN), indicated generally at 5. At some time after charging is complete, the thyratron 2 is triggered to cause a current pulse to be applied to the load 1 via a pulse transformer 6. After transmission of the pulse, the thyratron 2 remains in its conducting state. In order for the thyratron to be turned off, its anode electrode must be made to be not more positive than its cathode and, in practice the anode must be made more negative than the cathode. If such an inverse voltage is not maintained for a sufficiently long period across the thyratron 2, forward recovery does not occur and the thyratron 2 will continue to conduct, diverting the charging current and thus preventing recharging of the PFN 5.

If the load circuit contains a shunt inductive element, as may be provided by the core of a pulse- transformer, particularly when an air-gap is employed in the latter, the effect is to maintain forward current in thyratron 2 for a period of time following the useful part of the pulse, irrespective of the residual voltage across the PFN 5. This continuing current tends to charge the PFN 5 in the direction of reversed polarity (in comparison with the polarity of charge brought about by the action of the recharging circuit consisting of the inductor 3 and the diode 4), and if the recharging current remains sufficiently small during the recovery period of thyratron 2, will result in a net reverse voltage on the PFN at the time when the current in this direction falls to zero, irrespective of the magnitude and polarity of the residual voltage which was present on the PFN at the end of the useful part of the pulse. At this time, the energy which has been stored in the shunt inductor as a result of the load voltage developed across it, has all been returned to the circuit. Magnetising current then builds up in the inductor in the reverse direction as energy flows back into the transformer core from the PFN 5. This reverse magnetising current, minus the incoming current from the charging inductor 3, flows through an inverse diode and resistor 8, and an inverse voltage is developed across the thyratron 2 which permits recovery to occur.

Whilst the circuit arrangement illustrated in Figure 1 performs satisfactorily under some operating conditions, if the ratio of the pulse duration to charging time is too great, typically 1%, it may be difficult to ensure recovery of the thyratron 2 after transmission of the pulse. The incoming charging current from the charging inductor 3 may almost balance the magnetising current through the inverse diode and resistor 8, resulting in any inverse voltage being of too small a magnitude and therefore applied for too short a time for complete recovery to occur. This problem may be exacerbated during start-up and where the load has non-linear characteristics, such as, for example, a magnetron or a klystron, where it will often be necessary for the thyratron to be able to recover with an effective open circuit load.

The present invention seeks to provide an improved circuit arrangement which is particularly advantageous for applications in which the charging time is relatively short compared to the pulse duration.

According to the invention there is provided a circuit arrangement comprising a main switch having unidirectional conducting characteristics arranged to switch a current pulse through a load from charge storage means and an auxiliary switch arranged to switch across the main switch an inverse voltage produced across the charge storage means after transmission of the pulse through the load. The invention is applicable to circuits which include main switches such as thyratrons and thyristors in which an inverse voltage must be applied across them to enable them to be turned off. By employing the invention, it is possible to achieve commutation of the main switch without having to employ charge storage means additional to that from which the current pulse is derived. Recovery of the main switch may be achieved, even where operating conditions are not conducive to this, for example, the switch may be turned off even in cases where the charging time prior to transmission of the pulse is less than a hundred times greater than the duration of the pulse. The auxiliary switch may be arranged such that it need only carry a fraction of the average modulator current, and its cathode heater and triggering supplies may be at earth potential.

The invention may advantageously be employed where the load has non-linar characteristics and/or is unidirectionally conducting, such as for example, a magnetron or klystron.

Advantageously, an inductor is included, being connected in parallel with the load and arranged to produce the inverse voltage across the charge storage means. By including an inductor of suitable value connected in shunt with the said load, this serves to prolong the passage of current through the main switch after forward current in the load has ceased so that energy which has been stored in the inductor during the period of forward voltage across the load is returned to the said storage means by charging it with reversed polarity.

It is preferred that the charge storage means is a pulse forming network across which, after transmission of the pulse, a voltage is produced, and that the voltage comprises the inverse voltage switched by the auxiliary switch. One terminal of the main switch may be connected to the pulse forming network and another terminal to the pulse forming network via the auxiliary switch. Thus, when the auxiliary switch is triggered into conduction, the voltage developed across the pulse-forming network may be immediately applied across the main switch as an inverse voltage. It may be advantageous to ensure that the auxiliary switch is triggered before the inverse voltage developed across the pulse forming network is a maximum, as this maximises the time available for recovery. For a given arrangement, it is generally the case that the auxiliary switch may be triggered after a fixed time from the triggering of the main thyratron and still enable acceptable operation to be achieved over the necessary range of load impedance.

It is preferred that a transformer is included, the auxiliary switch being connected in parallel with its primary winding and the load in parallel with its secondary winding. The auxiliary switch must be able to withstand the pulse voltage on the primary of the pulse transformer as inverse voltage and may be protected by isolating it from the pulse transformer primary by including a solid state diode string in series with the auxiliary switch.

Some ways in which the invention may be performed are now described by way of example with reference to the accompanying drawings, in which:

Figure 2 illustrates a circuit arrangement in accordance with the invention; and

Figure 3 schematically illustrates another circuit arrangement in accordance with the invention.

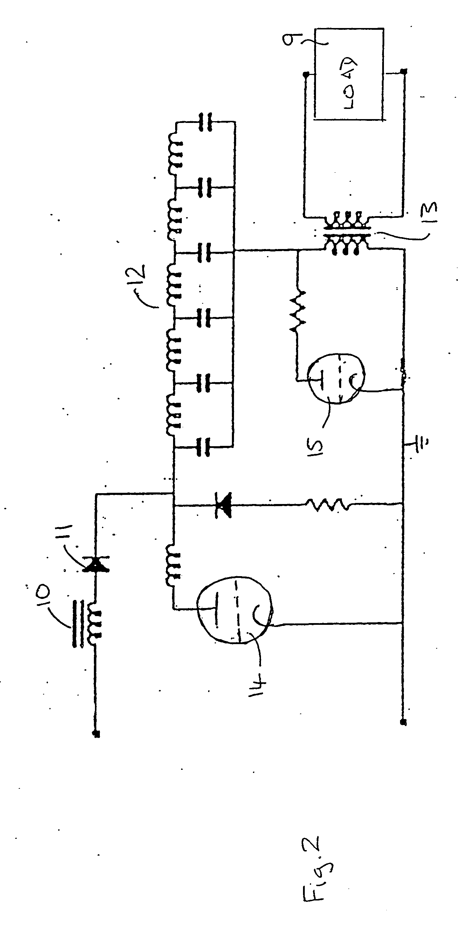

With reference to Figure 2, a circuit arrangement for driving a unidirectional conducting load, which in this case is a magnetron 9, includes an inductor 10 to which charging current is applied and which is followed by a diode 11. The circuit also includes a PFN 12, a pulse transformer 13 and a thyratron 14 similar to those of the circuit arrangement of Figure 1.

An auxiliary thyratron 15 is also included and is connected in inverse across the primary winding of the pulse transformer 13. After the main thyratron 14 has been triggered to cause a pulse to be transmitted through the magnetron 9, energy is exchanged from the core of transformer 13 to the pulse forming network 12. When this transfer is approaching completion, such that a near maximum inverse voltage is present across the pulse forming network 12, the auxiliary thyratron 15 is triggered. This causes the terminal of the pulse forming network 12 to which the thyratron 15 is connected, to be brought to earth potential and an inverse voltage is immediately applied across the main thyratron 14. The inverse voltage remains until the pulse forming network voltage rises to equal it as charging current is applied via the inductor 10. The auxiliary thyratron 15 is fired a short time before the maximum energy transfer is reached in order to maximise the time available for recovery of the main thyratron 14.

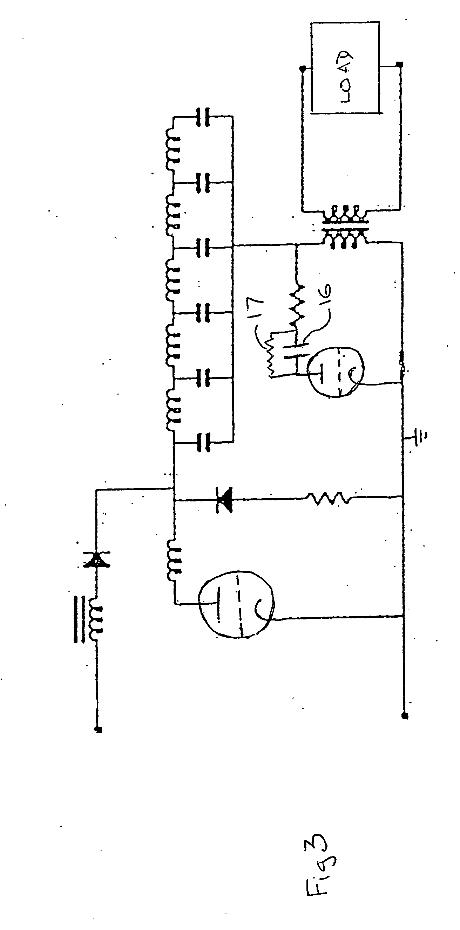

With reference to Figure 3, another circuit arangement in accordance with the invention is similar to that shown in Figure 2 but includes an additional capacitor 16 arranged in series with the auxiliary thyratron. This enables the auxiliary thyratron to be switched off sooner than would otherwise be the case, thus reducing the total charge passed by the auxiliary thyratron during the re-charging period and therefore the energy loss occuring within it. A resistor 17 is included across the capacitor 16 to enable it to be discharged.

In another embodiment of the invention (not shown), the auxiliary switch is connected into the circuit via an auxiliary winding of the transformer. This is particularly advantageous where a thyristor, for example, is used as the auxiliary switch.

## Claims

1. A circuit arrangement comprising a main switch (14) having unidirectional conducting characteristics arranged to switch a current pulse through a load (9) from charge storage means (12) and an auxiliary switch (15) arranged to switch across the main switch (14) an inverse voltage produced across the charge storage means (12) after transmission of the pulse through the load (9).

2. An arrangement as claimed in claim 1 and including an inductor (13), connected in parallel with the load (9) arranged to produce the inverse voltage across the charge storage means (12).

3. An arrangement as claimed in claim 1 or claim 2 wherein the charge storage means is a pulse forming network (12) across which, after transmission of the pulse, a voltage is produced, the voltage comprising the inverse voltage switched by the auxiliary switch (15).

4. An arrangement as claimed in claim 3, wherein one terminal of the main switch (14) is connected to the pulse forming network (12) and another terminal to the pulse forming network via the auxiliary switch (15).

5. An arrangement as claimed in any preceding claim and including means for triggering the auxiliary switch (15) before the voltage developed across the charge storage means reaches a maximum inverse value.

6. An arrangement as claimed in any preceding claim wherein a capacitor (16) is included in series with the auxiliary switch.

7. An arrangement as claimed in any preceding claim and including a transformer (13) the auxiliary switch (15) being connected in parallel with its primary winding and the load (9) in parallel with its secondary winding.

8. An arrangement as claimed in any of claims 1 to 6 and including a transformer, the auxiliary switch being connect across an auxiliary winding of the transformer.

9. An arrangement as claimed in any preceding claim wherein the main switch is a thyratron (14).

10. An arrangement as claimed in any preceding claim wherein the auxiliary switch is a thyratron (15).

11. An arrangement as claimed in any preceding claim wherein the load (9) is unidirectionally conducting.

· 12. An arrangement as claimed in claim 11 wherein the load is a klystron.

13. An arrangement as claimed in claim 11 wherein the laod is a magnetron.

14. An arrangement as claimed in any preceding claim wherein the charging time is less than one hundred times greater than the pulse duration.

Fig. 1

Fig. 2

Fig 3